(19) Europäisches Patentamt
European Patent Office
Office européen des brevets

(11) EP 3 038 438 B1

(12) EUROPEAN PATENT SPECIFICATION

(45) Date of publication and mention of the grant of the patent:
**26.05.2021 Bulletin 2021/21**

(51) Int Cl.:
***H05K 1/02*** *(2006.01)* ***H05K 7/14*** *(2006.01)*

(21) Application number: **15201535.0**

(22) Date of filing: **21.12.2015**

(54) **PRINTED CIRCUIT BOARD AND MOTOR DRIVE APPARATUS INCLUDING THE PRINTED CIRCUIT BOARD**

LEITERPLATTE UND MOTORANTRIEBSVORRICHTUNG MIT DER LEITERPLATTE

CARTE DE CIRCUIT IMPRIMÉ ET APPAREIL D'ENTRAÎNEMENT DE MOTEUR COMPRENANT LADITE CARTE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **22.12.2014 KR 20140186218**

(43) Date of publication of application:
**29.06.2016 Bulletin 2016/26**

(73) Proprietor: **LG Electronics Inc.**
**Seoul 07336 (KR)**

(72) Inventors:
- **LEE, Jungdae**
  **08592 Seoul (KR)**
- **KIM, Jongwon**
  **08592 Seoul (KR)**
- **LEE, Kyunghoon**
  **08592 Seoul (KR)**
- **LEE, Gilsu**
  **08592 Seoul (KR)**

(74) Representative: **Vossius & Partner Patentanwälte Rechtsanwälte mbB**
**Siebertstrasse 3**
**81675 München (DE)**

(56) References cited:
**EP-A1- 2 651 015**
**WO-A1-2012/137597**
**JP-A- 2011 033 479**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 038 438 B1

## Description

Embodiments relate to a printed circuit board and a motor drive apparatus including the printed circuit board.

In general, a vacuum cleaner creates a suction state in the interior of a main body by driving a motor, thus causing, for example, dust to be suctioned to the interior of the main body by suction force. To this end, the motor used in the vacuum cleaner may be driven by drive power supplied from an inverter which includes three-phase switch elements.

EP 2651015 A1, WO 2012/137597 A1 and JP 2011 033479 A are related technology to the present invention.

Here, the three-phase switch elements show an increase in the number of switching times according to the drive time and the drive speed of the motor, and heat may be generated inside the elements.

Because the three-phase switching elements described above are mounted on a printed circuit board, a copper foil layer may be formed on the printed circuit board so as to absorb and radiate the heat in the three-phase switch elements.

Here, the three-phase switch elements show an increase in the number of switching times according to the drive time

In recent years, in order to sense whether the three-phase switch elements are damaged or rendered nonfunctional by the heat generated therein, studies have been conducted to measure the heat in the three-phase switch elements.

The invention is specified in the claims.

Embodiments provide a printed circuit board according to independent claim 1, and a motor drive apparatus including the printed circuit board according to claim 7.

Details of the embodiments will be more clearly understood from the following detailed description taken in conjunction with the accompanying drawings, in which:

FIG. 1 is a perspective view illustrating a portion of a printed circuit board according to an exemplary embodiment;

FIG. 2 is an exploded perspective view illustrating the printed circuit board of FIG. 1;

FIG. 3 is an enlarged view of the portion "A" illustrated in FIG. 2;

FIG. 4 is a control block diagram illustrating the control configuration of a motor drive apparatus according to an exemplary embodiment;

FIG. 5 is a circuit diagram illustrating a heat measurement unit of FIG. 4; and

FIG. 6 is a circuit diagram illustrating a second embodiment of the heat measurement unit of FIG. 4.

Reference will now be made in detail to embodiments, examples of which are illustrated in the accompanying drawings. However, the present disclosure may be embodied in many different forms and should not be construed as limited to the embodiments set forth herein. Rather, these embodiments are provided so that this disclosure will be thorough and complete, and will fully convey the scope of the disclosure to those skilled in the art. The present disclosure is defined only by the categories of the claims. In certain embodiments, detailed descriptions of device constructions or processes well known in the art may be omitted to avoid obscuring appreciation of the disclosure by a person of ordinary skill in the art. Wherever possible, the same reference numbers will be used throughout the drawings to refer to the same or like parts.

Unless otherwise defined, all terms (including technical and scientific terms) used herein have the same meaning as commonly understood by one of ordinary skill in the art. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Hereinafter, exemplary embodiments will be described in more detail with reference to the accompanying drawings.

FIG. 1 is a perspective view illustrating a portion of a printed circuit board according to an exemplary embodiment, and FIG. 2 is an exploded perspective view illustrating the printed circuit board of FIG. 1.

The printed circuit board 100 illustrated in FIGS. 1 and 2 indicates an inverter unit (not illustrated), which supplies drive power to a motor (not illustrated).

Although the description of the embodiment will be limited to the inverter unit, the description may be applied to other units that are at risk of being damaged by heat generation, without limitation to the inverter unit.

Referring to FIGS. 1 and 2, the printed circuit board 100 is provided with three-phase switch elements s1, s2, s3, s4, s5 and s6 for an inverter, and a thermistor element NTC 1.

At this time, the printed circuit board 100 includes a base layer (not illustrated), a copper foil layer 110 on the base layer, the copper foil layer 110 being formed with a circuit pattern, and an insulation layer 120 on the copper foil layer 110.

Here, the base layer may be formed of an FR4 material or a metal material. In the following description of the embodiment, the base layer will be described as being formed of the FR4 material.

The copper foil layer 110 includes solder patterns sp1, sp2, sp3, sp4, sp5 and sp6, to which the three-phase inverter switch elements s1, s2, s3, s4, s5 and s6 for the supply of drive power to the motor (not illustrated) are soldered, heat radiation patterns hp1 and hp2 which are spaced apart from the solder patterns sp1, sp2, sp3, sp4, sp5 and sp6 and come into contact with one surface of the respective three-phase switch elements s1, s2, s3, s4, s5 and s6 so as to absorb and radiate heat in the three-phase switch elements s1, s2, s3, s4, s5 and s6, a heat circulation pattern hs1, through which the heat absorbed by the heat radiation patterns hp1 is circulated, and element patterns (not illustrated) formed on both sides of the heat circulation pattern hs1, to which the thermistor element NTC1 is soldered such that the resistance value of the thermistor element NTC1 is varied according to the heat circulating through the heat circulation patterns hs1.

Here, the solder patterns sp1, sp2, sp3, sp4, sp5 and sp6 are soldered to three terminals of the three-phase switch elements s1, s2, s3, s4, s5 and s6.

In the embodiment, the three-phase switch elements s1, s2, s3, s4, s5 and s6 will be described as FETs. The FET may include a drain, a gate and a source, and may connect the drain and the source to each other in response to a gate signal input to the gate, thereby generating a PWM signal and supplying the same to the motor.

That is, each of the solder patterns sp1, sp2, sp3, sp4, sp5 and sp6 is connected to three terminals of a corresponding one of the three-phase switch elements s1, s2, s3, s4, s5 and s6, and may include a signal line (not illustrated) through which a gate signal is applied to the gate of each of the three-phase switch elements s1, s2, s3, s4, s5 and s6 as described above, a power line (not illustrated) connected to the drain, and a power line (not illustrated) connected to the source, without being limited thereto.

The heat radiation pattern hp1 comes into contact with a single surface that is common to all of the three-phase switch elements s1, s2 and s3, thereby absorbing and radiating heat in the three-phase switch elements s1, s2 and s3.

Likewise, the heat radiation pattern hp2 comes into contact with a single surface that is common to all of the three-phase switch elements s4, s5 and s6, thereby absorbing and radiating heat in the three-phase switch elements s4, s5 and s6.

The heat circulation pattern hs1 is connected to the heat radiation pattern hp1, and circulates the heat absorbed from the heat radiation pattern hp1.

Here, although the heat circulation pattern hs1 has been illustrated and described as being connected to any one heat radiation pattern hp1 among the heat radiation patterns hp1 and hp2, the heat circulation pattern hs1 may be connected to the heat radiation pattern hp2, without being limited thereto.

In addition, although the heat radiation patterns hp1 and hp2 are illustrated as being separated from each other, the heat radiation patterns hp1 and hp2 may be formed as a single pattern, without being limited thereto.

At this time, the heat circulation pattern hs1 may have a "U"-shaped form to enable the circulation of heat absorbed by the heat radiation pattern hp1.

The element patterns is located close to both sides of the heat circulation pattern hs1, and the thermistor element NTC1 is soldered to the element patterns.

At this time, the element patterns may be configured as via-hole patterns, without being limited thereto.

The insulation layer 120 may be disposed on the copper foil layer 110, and may form open regions so1, so2, so3, so4, so5 and so6 to allow the respective three-phase switch elements s1, s2, s3, s4, s5 and s6 to be soldered to the respective solder patterns sp1, sp2, sp3, sp4, sp5 and sp6, and may also form an open region no1 to allow each thermistor element NTC1 to be soldered to the respective element patterns.

FIG. 3 is an enlarged view of the portion "A" illustrated in FIG. 2.

FIG. 3 illustrates the heat radiation pattern hp1, the heat circulation pattern hs1, and the element pattern np1.

That is, referring to FIG. 3, the thermistor element NTC1 includes first and second electrode portions b1 and b2, and an insulator portion a between the first and second electrode portions b1 and b2.

In the embodiment, the thermistor element NTC1 will be described as being located between the second-phase and third-phase switch elements s2 and s3 among the three-phase switch elements s1, s2 and s3 so as to be close to the second-phase switch element s2.

Here, the thermistor element NTC1 is located close to the second-phase switch element s2, and thus may achieve the advantage of simultaneously measuring heat in the second-phase switch element s2 and heat which is absorbed and circulated through the heat circulation pattern hs1.

Here, the first and second electrode portions b1 and b2 may be soldered to the element pattern np1.

The insulator portion a vertically overlaps the heat circulation pattern hs1 from the upper side thereof, and indirectly reacts to the heat circulated through the heat circulation pattern hs1 such that the resistance value thereof may be varied.

The heat radiation pattern hp1 absorbs and radiates heat in the three-phase switch elements s1, s2 and s3 as described above with reference to FIGS. 1 and 2.

At this time, the heat absorbed by the heat radiation pattern hp1 is conducted to the heat circulation pattern hs1, so as to be circulated through the heat circulation pattern hs1.

The element pattern np1 may include first and second via-hole patterns h1 and h2, to which the first and second electrode portions b1 and b2 are soldered, the first and second via-hole patterns h1 and h2 being formed through the base layer (not illustrated).

At this time, the first and second via-hole patterns h1 and h2 may be formed through a first surface of the base layer and a second surface thereof, which is opposite to the first surface.

Here, the second surface of the base layer may be provided with a heat measurement pattern (not illustrated), which is connected to at least one of the first and second via-hole patterns h1 and h2 such that other elements are disposed on the heat measurement pattern to measure heat based on the variable resistance value of the thermistor element NTC1, without being limited thereto.

At this time, the width d of the insulator portion a or the distance (not illustrated) between the first and second electrode portions b1 and b2 may be greater than the width b of the heat circulation pattern hs1. When the width d or the distance is less than the width b of the heat circulation pattern hs1, the first and second electrode portions b1 and b2 are at risk of forming a short-circuit due to the heat circulation pattern hs1.

In the printed circuit board 100 according to the embodiment, as a result of forming the heat circulation pattern hs1, through which the heat absorbed by the heat radiation pattern hp1 is circulated, and of forming the element pattern np1 such that the thermistor element NTC1 is disposed on the element pattern np1 so as to vertically overlap the heat circulation pattern hs1 from the upper side thereof, the abnormal operation of at least one of the three-phase switch elements s1, s2, s3, s4, s5 and s6 may be advantageously checked based on the thermal voltage measured by the NTC1 when the printed circuit board 100 is applied to a motor drive apparatus 200.

FIG. 4 is a control block diagram illustrating the control configuration of the motor drive apparatus according to an exemplary embodiment, and FIG. 5 is a circuit diagram illustrating a first embodiment of a heat measurement unit of FIG. 4.

Referring to FIGS. 4 and 5, the motor drive apparatus 200 may include a converter unit 210, an inverter unit 220, a heat measurement unit 230, and a motor controller 240.

The converter unit 210 may include a rectifier circuit which rectifies commercial power, i.e. converts AC power into DC power.

The inverter unit 220 includes the three-phase switch elements s1, s2, s3, s4, s5 and s6, which are soldered to the solder patterns sp1, sp2, sp3, sp4, sp5 and sp6 formed on the printed circuit board 100 as described above with reference to FIGS. 1 to 3, and come into contact, on at least one surface thereof, with the heat radiation patterns hp1 and hp2 which absorb and radiate heat, and supply drive power to a motor M.

At this time, the three-phase switch elements s1, s2, s3, s4, s5 and s6 perform switching in response to gate signals applied from the motor controller 240, so as to output the drive power to the motor M.

The heat measurement unit 230 is disposed on the heat circulation pattern hs1 connected to the heat radiation pattern hp1, and outputs the thermal voltage Vntc, which corresponds to the heat circulated from the heat radiation pattern hp1 to the heat circulation pattern hs1.

That is, the heat measurement unit 230, as illustrated in FIG. 5, may include a thermistor element NTC, a reference resistor R1, and an RC resonance filter composed of a resistor R2 and a capacitor C.

In the embodiment, the heat measurement unit 230 will be described as measuring the thermal voltage Vntc with the thermistor element NTC1 illustrated in FIGS. 1 to 3, and the thermistor element NTC will be described as being the thermistor element NTC1 illustrated in FIGS. 1 to 3.

The thermistor element NTC is soldered to the element pattern npl formed on both sides of the heat circulation pattern hs1 on the printed circuit board 100, and vertically overlaps the heat circulation pattern hs1 from the upper side thereof.

The resistance value of the thermistor element NTC decreases in proportion to the heat.

At this time, the reference resistor R1 may be connected to the thermistor element NTC in parallel with a distribution contact p interposed therebetween.

In addition, the RC filter may be connected to the distribution contact p, and may remove noise from the thermal voltage Vntc applied to the distribution contact p so as to output the thermal voltage Vntc to the motor controller 240.

That is, the thermal voltage Vntc is a distribution voltage that is applied to the distribution contact p as a reference voltage Vcc is supplied to one side of the thermistor element NTC.

The thermal voltage Vntc may be variable as the resistance value of the thermistor element NTC is varied by heat, and may be calculated using the following Equation 1.

Equation 1

$$Vntc = \frac{R1}{(Rntc + R1)} Vcc$$

Here, Vntc indicates the thermal voltage of the thermistor element NTC, Rntc indicates the resistance value of the thermistor element NTC, R1 indicates the resistance value of the reference resistor, and Vcc indicates a reference voltage.

Meanwhile, the resistance value Rntc of the thermistor element NTC is a resistance value that is varied by heat.

For example, when the resistance value Rntc of the thermistor element NTC is 5 KΩ, the reference voltage Vcc is 5V, and the reference resistance R1 is 1 KΩ in a normal state, the thermal voltage Vntc is 0,833 V.

However, when the resistance value Rntc of the thermistor element NTC decreases to 1 KΩ in a high temperature state, the thermal voltage Vntc may increase to 2.5 V.

The motor controller 240 may control the inverter unit 220, and may control the driving of the motor M by comparing the thermal voltage Vntc output from the heat measurement unit 230 with a reference thermal voltage which is set to control the driving of the motor M.

That is, when the thermal voltage Vntc is less than the reference thermal voltage, the motor controller 240 may judge that at least one of the three-phase switch elements s1, s2, s3, s4, s5 and s6 included in the inverter unit 220 is operating abnormally, and may control the three-phase switch elements s1, s2, s3, s4, s5 and s6 so as to stop the operation of the motor M.

The motor drive device 200 according to the embodiment may monitor the state of the three-phase switch elements s1, s2, s3, s4, s5 and s6 based on the thermal voltage Vntc corresponding to the heat in the three-phase switch elements s1, s2, s3, s4, s5 and s6, and may control the motor M so as to stop the operation of the motor M upon the abnormal operation of the switch element(s).

FIG. 6 is a circuit diagram illustrating a second embodiment of the heat measurement unit of FIG. 4.

FIG. 6, in which configurations that are the same as those of FIGs. 4 and 5 are not illustrated and described, is a diagram of a circuit that uses a PCT thermistor, which is different from the thermistor element of FIG. 5.

Referring to FIG. 6, the heat measurement unit 230, as exemplarily illustrated in FIG. 6, may include the thermistor element PTC, the reference resistor R1, and the RC resonance filter composed of the resistor R2 and the capacitor C.

Here, FIG. 6 will be described with the same reference numerals as those in FIG. 5.

The thermistor element PTC is soldered to the element pattern np1 formed on both sides of the heat circulation pattern hs1 on the printed circuit board 100, and vertically overlaps the heat circulation pattern hs1 from the upper side thereof.

The thermistor element PCT may be a PCT thermistor element, the resistance value of which increases in proportion to the heat.

At this time, the reference resistor R1 may be connected to the thermistor element PTC in parallel with the distribution contact p interposed therebetween.

In addition, the RC filter may be connected to the distribution contact p, and may remove noise from the thermal voltage Vptc applied to the distribution contact p so as to output the thermal voltage Vptc to the motor controller 240.

Here, the thermal voltage Vptc is a distribution voltage that is applied to the distribution contact p by the resistance value of the thermistor element PCT as a reference voltage Vcc is supplied to one side of the reference resistor R1.

Equation 2

$$Vptc = \frac{Rptc}{(Rptc + R1)} Vcc$$

Here, Vptc indicates the thermal voltage of the thermistor element PTC, Rptc indicates the resistance value of the thermistor element PTC, R1 indicates the resistance value of the reference resistor, and Vcc indicates a reference voltage.

Meanwhile, the resistance value Rptc of the thermistor element PTC is a resistance value that is varied by heat.

For example, when the resistance value Rptc of the thermistor element PTC is 1 KΩ, the reference voltage Vcc is 5V, and the reference resistance R1 is 1 KΩ in a normal state, the thermal voltage Vptc is 2.5 V.

However, when the resistance value Rptc of the thermistor element PTC increases to 5 KΩ in a high temperature state, the thermal voltage Vptc may increase to 4.167 V.

The motor controller 240 may control the inverter unit 220, and may control the driving of the motor M by comparing the thermal voltage Vptc output from the heat measurement unit 230 with a reference thermal voltage which is set to control the driving of the motor M.

That is, when the thermal voltage Vptc is less than the reference thermal voltage, the motor controller 240 may judge that at least one of the three-phase switch elements s1, s2, s3, s4, s5 and s6 included in the inverter unit 220 is operating abnormally, and may control the three-phase switch elements s1, s2, s3, s4, s5 and s6 so as to stop the operation of the motor M.

The motor drive device 200 according to the embodiment may monitor the state of the three-phase switch elements s1, s2, s3, s4, s5 and s6 based on the thermal voltage Vptc corresponding to the heat in the three-phase switch elements s1, s2, s3, s4, s5 and s6, and may control the motor M so as to stop the operation of the motor M upon the abnormal operation of the switch element(s).

As is apparent from the above description, in a printed circuit board and a motor drive apparatus including the printed circuit board, by providing a heat radiation pattern, which comes into contact with a single surface that is common to all of inverter switch elements so as to absorb and radiate heat in the inverter switch elements, a heat circulation pattern connected to the heat radiation pattern such that the heat absorbed by the heat radiation pattern is circulated through the heat circulation pattern, and an element pattern formed on the heat circulation pattern so as to allow a thermistor element to indirectly measure the heat, the heat in the switch elements may be advantageously measured in an indirect manner.

It will be further understood that the terms "include", "constitute", or "have" when used in this specification, specify the presence of stated components, unless otherwise defined, and thus should be construed as further including other components, rather than precluding other components.

## Claims

**1.** A printed circuit board (100) comprising three-phase switch elements and a thermistor element, the printed circuit board further comprising:

a copper foil layer (100) to form a circuit pattern on a base layer; and
an insulation layer (120) laminated on the copper foil layer,
wherein the circuit pattern includes:

an inverter unit (220) including three-phase switch elements (s1, s2, s3, s4, s5, s6) each soldered to a solder pattern (sp1, sp2, sp3, sp4, sp5, sp6);
the solder pattern (sp1, sp2, sp3, sp4, sp5, sp6), to which an inverter switch element (s1, s2, s3, s4, s5, s6) is soldered to supply drive power to a motor;
a heat radiation pattern (hp1, hp2) spaced apart from the solder pattern (sp1, sp2, sp3, sp4, sp5, sp6) and to contact with one surface of the inverter switch element so as to absorb and radiate heat in the inverter switch element;
a heat circulation pattern (hs1), through which the heat absorbed from the heat radiation pattern is circulated; and
an element pattern (np1) formed on both sides of the heat circulation pattern where the thermistor element (NTC1 or PTC), a resistance value of which is varied according to the heat, is soldered to the element pattern;

**characterized by**
a heat measurement pattern to measure the heat based on the variable resistance value of the thermistor element (NTC1 or PTC),
wherein the thermistor element (NTC or PTC) is disposed on the heat circulation pattern so as to vertically overlap the heat circulation pattern,
wherein the thermistor element is located close to any one switch element among the three-phase switch elements;
wherein the thermistor element (NTC or PTC) includes:

first and second conductor portion soldered to the element pattern; and an insulator portion (a) disposed on the heat circulation pattern such that a resistance value thereof is varied by the heat, and
wherein a distance between the first and second conductor portions or a width (d) of the insulator portion is greater than a width (b) of the heat circulation pattern.

**2.** The printed circuit board according to claim 1, wherein the heat circulation pattern is formed on at least one side of the heat radiation pattern and has a U-shaped form.

**3.** The printed circuit board according to claim 1 or 2, wherein the thermistor element is an NTC thermistor, the resistance value of which decreases in proportion to the heat, or a PCT thermistor, the resistance value of which increases in proportion to the heat.

**4.** The printed circuit board according to claim 1, wherein the element pattern includes first and second via-hole patterns soldered to the first and second conductor portions.

**5.** The printed circuit board according to claim 4, wherein the first and second via-hole patterns are formed through a first surface of the base layer and a second surface, which is opposite to the first surface.

**6.** The printed circuit board according to claim 5, wherein the heat measurement pattern is formed on the second surface and is connected to any one of the first and second via-hole patterns.

**7.** A motor drive apparatus comprising three-phase switch elements and a thermistor element, the motor drive apparatus further comprising:

an inverter unit (200) including three-phase switch elements each soldered to a solder pattern formed on a printed circuit board (100) and in contact, on at least one surface thereof, with a heat radiation pattern, which is to absorb and radiate heat;
a heat measurement unit (230), which is disposed on a heat circulation pattern connected to the heat radiation pattern and outputs a thermal voltage corresponding to heat circulated from the heat radiation pattern to the heat circulation pattern; and
a motor controller (240) to control the three-phase switch elements such that a motor, which is driven by drive power supplied from the inverter unit, stops operation by comparing the thermal voltage with a reference thermal voltage set to control driving of the motor,
wherein the heat measurement unit (230) includes:

a thermistor element soldered to an element pattern formed on both sides of the heat circulation pattern on the printed circuit board, the thermistor element being disposed on the heat circulation pattern so as to vertically overlap the heat circulation pattern, a resistance value of thermistor element being varied in proportion to the heat; and
a heat measurement pattern to measure the heat based on the variable resistance value of the thermistor element (NTC or PTC),

wherein the thermistor element is located close to any one switch element among the three-phase switch elements,
wherein the thermistor element(NTC or PTC) includes:

first and second conductor portions soldered to the element pattern; and
an insulator portion (a) disposed on the heat circulation pattern such that a resistance value thereof is varied by the heat, and

wherein a distance between the first and second conductor portions or a width (d) of the insulator portion is greater than a width (b) of the heat circulation pattern.

8. The motor drive apparatus according to claim 7, wherein the thermistor element is an NTC thermistor, a resistance value of which decreases in proportion to the heat.

9. The motor drive apparatus according to claim 7, wherein the heat measurement unit (230) further includes:

a reference resistor (R1), one side of which receives a reference voltage applied thereto, and a remaining side of which is connected to one side of the thermistor element at a distribution contact; and
an RC resonance filter, which is connected to the distribution contact and is to remove noise from the thermal voltage applied to the distribution contact and to output the thermal voltage to the motor controller.

10. The motor drive apparatus according to claim 9, wherein a reference voltage is applied to one side of the thermistor element.

11. The motor drive apparatus according to claim 9 or 10, wherein the thermistor element is a PCT thermistor, a resistance value of which increases in proportion to the heat.

12. The motor drive apparatus according to claim 7, wherein the three-phase switch elements include a first-phase switch element, a third-phase switch element, and a second-phase switch element located between the first-phase switch element and the third-phase switch element, and
wherein the thermistor element is located close to the second-phase switch element.

13. The motor drive apparatus according to claim 7, wherein when the thermal voltage (Vptc) is less than the reference thermal voltage, the motor controller (240) controls the three-phase switch elements to stop operation of the motor.

**Patentansprüche**

1. Leiterplatte (100) mit dreiphasigen Schaltelementen und einem Thermistorelement, wobei die Leiterplatte ferner aufweist:

eine Kupferfolienschicht (100), die ein Schaltungsmuster auf einer Basisschicht bildet; und
eine Isolierschicht (120), die auf die Kupferfolienschicht laminiert ist,
wobei das Schaltungsmuster aufweist:

eine Wechselrichtereinheit (220), die dreiphasige Schaltelemente (s1, s2, s3, s4, s5, s6) aufweist, die jeweils auf ein Lötmuster (sp1, sp2, sp3, sp4, sp5, sp6) gelötet sind;
wobei das Lötmuster (sp1, sp2, sp3, sp4, sp5, sp6), an das ein Wechselrichter-Schaltelement (s1, s2, s3, s4, s5, s6) gelötet ist, Antriebsstrom an einen Motor liefern soll;
ein Wärmeabstrahlungsmuster (hp1, hp2), das vom Lötmuster (sp1, sp2, sp3, sp4, sp5, sp6) beabstandet ist und eine Oberfläche des Wechselrichter-Schaltelements berühren soll, um Wärme im Wechselrichter-Schaltelement aufzunehmen und abzustrahlen;
ein Wärmeumwälzungsmuster (hs1), durch das die vom Wärmeabstrahlungsmuster aufgenommene Wärme umgewälzt wird; und
eine Elementmuster (np1), das auf beiden Seiten des Wärmeumwälzungsmusters ausgebildet ist, wo das Thermistorelement (NTC1 oder PTC), dessen Widerstandswert entsprechend der Wärme variiert, auf das Elementmuster gelötet ist;

**gekennzeichnet durch**
ein Wärmemessmuster, um die Wärme beruhend auf dem variablen Widerstandswert des Thermistorelements (NTC1 oder PTC) zu messen,
wobei das Thermistorelement (NTC oder PTC) auf dem Wärmeumwälzungsmuster so angeordnet ist, dass es sich vertikal mit dem Wärmeumwälzungsmuster überlappt, wobei das Thermistorelement in der Nähe zu einem beliebigen Schaltelement unter den dreiphasigen Schaltelementen angeordnet ist;
wobei das Thermistorelement (NTC oder PTC) aufweist:

einen ersten und zweiten Leiterabschnitt, die an das Elementmuster gelötet sind; und
einen Isolatorabschnitt (a), der auf dem Wärmeumwälzungsmuster so angeordnet ist, dass dessen Widerstandswert durch die Wärme variiert wird, und

wobei ein Abstand zwischen dem ersten und zweiten Leiterabschnitt oder eine Breite (d) des Isolatorabschnitts größer als eine Breite (b) des Wärmeumwälzungsmusters ist.

**2.** Leiterplatte nach Anspruch 1, wobei das Wärmeumwälzungsmuster auf mindestens einer Seite des Wärmeabstrahlungsmusters ausgebildet ist und eine U-förmige Form aufweist.

**3.** Leiterplatte nach Anspruch 1 oder 2, wobei das Thermistorelement ein NTC-Thermistor, dessen Widerstandswert proportional zur Wärme abnimmt, oder ein PCT-Thermistor ist, dessen Widerstandswert proportional zur Wärme zunimmt.

**4.** Leiterplatte nach Anspruch 1, wobei das Elementmuster ein erstes und zweites Durchgangslochmuster aufweist, die an den ersten und zweiten Leiterabschnitt gelötet sind.

**5.** Leiterplatte nach Anspruch 4, wobei das erste und zweite Durchgangslochmuster durch eine erste Oberfläche der Basisschicht und eine zweite Oberfläche ausgebildet sind, die der ersten Oberfläche gegenüberliegt.

**6.** Leiterplatte nach Anspruch 5, wobei das Wärmemessmuster auf der zweiten Oberfläche ausgebildet ist und mit einem beliebigen des ersten und zweiten Durchgangslochmusters verbunden ist.

**7.** Motorantriebsvorrichtung mit dreiphasigen Schaltelementen und einem Thermistorelement, wobei die Motorantriebsvorrichtung ferner aufweist:

ein Wechselrichtereinheit (200), die dreiphasige Schaltelemente aufweist, die jeweils an ein Lötmuster gelötet sind, das auf einer Leiterplatte (100) ausgebildet ist, und die an mindestens einer Oberfläche davon mit einem Wärmeabstrahlungsmuster in Kontakt steht, das dazu dient, Wärme aufzunehmen und abzustrahlen;
eine Wärmemesseinheit (230), die auf einem Wärmeumwälzungsmuster angeordnet ist, das mit dem Wärmeabstrahlungsmuster verbunden ist, und eine Thermospannung abgibt, die der vom Wärmeabstrahlungsmuster zum Wärmeumwälzungsmuster umgewälzten Wärme entspricht; und
eine Motorsteuereinheit (240), um die dreiphasigen Schaltelemente so zu steuern, dass ein Motor, der durch den von der Wechselrichtereinheit zugeführten Antriebsstrom angetrieben wird, den Betrieb stoppt, indem die Thermospannung mit einer Thermoreferenzspannung verglichen wird, die zur Steuerung des Antriebs des Motors eingestellt ist,
wobei die Wärmemesseinheit (230) aufweist:

ein Thermistorelement, das an ein Elementmuster gelötet ist, das auf beiden Seiten des Wärmeumwälzungsmusters auf der Leiterplatte ausgebildet ist, wobei das Thermistorelement am Wärmeumwälzungsmuster so angeordnet ist, dass es sich vertikal mit dem Wärmeumwälzungsmuster überlappt, wobei ein Widerstandswert des Thermistorelements proportional zur Wärme variiert wird; und
ein Wärmemessmuster, um die Wärme beruhend auf dem variablen Widerstandswert des Thermistorelements (NTC oder PTC) zu messen, wobei das Thermistorelement in der Nähe zu einem beliebigen Schaltelement unter den dreiphasigen Schaltelementen angeordnet ist,

wobei das Thermistorelement (NTC oder PTC) aufweist:

einen ersten und zweiten Leiterabschnitt, die an das Elementmuster gelötet sind; und
einen Isolatorabschnitt (a), der auf dem Wärmeumwälzungsmuster so angeordnet ist, dass dessen Widerstandswert durch die Wärme variiert wird, und

wobei ein Abstand zwischen dem ersten und zweiten Leiterabschnitt oder eine Breite (d) des Isolatorabschnitts größer als eine Breite (b) des Wärmeumwälzungsmusters ist.

**8.** Motorantriebsvorrichtung nach Anspruch 7, wobei das Thermistorelement ein NTC-Thermistor ist, dessen Widerstandswert proportional zur Wärme abnimmt.

**9.** Motorantriebsvorrichtung nach Anspruch 7, wobei die Wärmemesseinheit (230) ferner aufweist:

einen Referenzwiderstand (R1), dessen eine Seite eine daran angelegte Referenzspannung aufnimmt und dessen verbleibende Seite mit einer Seite des Thermistorelements an einem Verteilungskontakt verbunden ist; und
ein RC-Resonanzfilter, das mit dem Verteilungskontakt verbunden ist und dazu dient, Rauschen aus der Thermospannung zu entfernen, die an den Verteilungskontakt angelegt wird, und die Thermospannung an die Motorsteuereinheit auszugeben.

**10.** Motorantriebsvorrichtung nach Anspruch 9, wobei eine Referenzspannung an eine Seite des Thermistorelement angelegt wird.

**11.** Motorantriebsvorrichtung nach Anspruch 9 oder 10, wobei das Thermistorelement ein PCT-Thermistor ist, dessen Widerstandswert proportional zur Wärme zunimmt.

**12.** Motorantriebsvorrichtung nach Anspruch 7, wobei die dreiphasigen Schaltelemente ein Schaltelement einer ersten Phase, ein Schaltelement einer dritten Phase und ein Schaltelement einer zweiten Phase aufweisen, das zwischen dem Schaltelement der ersten Phase und dem Schaltelement der dritten Phase angeordnet ist, und
wobei das Thermistorelement in der Nähe des Schaltelements der zweiten Phase angeordnet ist.

**13.** Motorantriebsvorrichtung nach Anspruch 7, wobei, wenn die Thermospannung (Vptc) kleiner als die Thermoreferenzspannung ist, die Motorsteuereinheit (240) die dreiphasigen Schaltelemente steuert, den Betrieb des Motors zu stoppen.

## Revendications

**1.** Carte de circuit imprimé (100) comprenant des éléments de commutation triphasés et un élément de thermistance, ladite carte de circuit imprimé comprenant en outre :

une couche de feuille de cuivre (100) destinée à former un motif de circuit sur une couche de base ; et
une couche isolante (120) stratifiée sur la couche de feuille de cuivre,
où le motif de circuit comprend :

une unité d'onduleur (220) comportant des éléments de commutation triphasés (s1, s2, s3, s4, s5, s6) soudés chacun à un motif de soudure (sp1, sp2, sp3, sp4, sp5, sp6) ;
le motif de soudure (sp1, sp2, sp3, sp4, sp5, sp6), auquel un élément de commutation d'onduleur (s1, s2, s3, s4, s5, s6) est soudé pour fournir une puissance d'excitation à un moteur ;
un motif de rayonnement thermique (hp1, hp2) espacé du motif de soudure (sp1, sp2, sp3, sp4, sp5, sp6) et en contact avec une surface de l'élément de commutation d'onduleur de manière à absorber et à irradier de la chaleur dans l'élément de commutation d'onduleur ;
un motif de circulation thermique (hs1), où est mise en circulation la chaleur absorbée du motif de rayonnement thermique ; et
un motif d'élément (np1) formé sur les deux côtés du motif de circulation thermique, l'élément de thermistance (NTC1 ou PTC), dont la valeur de résistance est variée en fonction de la chaleur, étant soudé au motif d'élément ;

**caractérisée par**
un motif de mesure de chaleur destiné à mesurer la chaleur sur la base de la valeur de résistance variable de l'élément de thermistance (NTC1 ou PTC),
l'élément de thermistance (NTC ou PTC) étant disposé sur le motif de circulation thermique de manière à chevaucher verticalement le motif de circulation thermique,
l'élément de thermistance étant disposé à proximité de n'importe quel élément de commutation parmi les éléments de commutation triphasés ;
l'élément de thermistance (NTC ou PTC) comprenant :

une première et une deuxième parties conductrices soudées au motif d'élément ; et
une partie isolante (a) disposée sur le motif de circulation thermique de manière à varier sa valeur de résistance sous l'effet de la chaleur, et
la distance entre la première et la deuxième parties conductrices, ou la largeur (d) de la partie isolante étant supérieure à la largeur (b) du motif de circulation thermique.

**2.** Carte de circuit imprimé selon la revendication 1, où le motif de circulation thermique est formé sur au moins un côté du motif de rayonnement thermique et a une forme en U.

**3.** Carte de circuit imprimé selon la revendication 1 ou la revendication 2, où l'élément de thermistance est une thermistance NTC, dont la valeur de résistance diminue proportionnellement à la chaleur, ou une thermistance PCT, dont la valeur de résistance augmente proportionnellement à la chaleur.

**4.** Carte de circuit imprimé selon la revendication 1, où le motif d'élément comprend un premier et un deuxième motifs de trous d'interconnexion soudés à la première et à la deuxième parties conductrices.

**5.** Carte de circuit imprimé selon la revendication 4, où le premier et le deuxième motifs de trous d'interconnexion sont formés dans une première surface de la couche de base et une deuxième surface opposée à la première surface.

**6.** Carte de circuit imprimé selon la revendication 5, où le motif de mesure de chaleur est formé sur la deuxième surface et est connecté au premier ou au deuxième motif de trous d'interconnexion.

**7.** Dispositif de commande de moteur comprenant des éléments de commutation triphasés et un élément de thermistance, ledit dispositif de commande de moteur comprenant en outre :

une unité d'onduleur (200) comprenant des éléments de commutation triphasés soudés chacun à un motif de soudure formé sur une carte de circuit imprimé (100) et en contact, sur au moins une surface de celle-ci, avec un motif de rayonnement thermique destiné à absorber et à irradier de la chaleur ;
une unité de mesure de chaleur (230) disposée sur un motif de circulation thermique connecté au motif de rayonnement thermique et sortant une tension thermoélectrique correspondant à la chaleur circulant du motif de rayonnement thermique vers le motif de circulation thermique ; et
un contrôleur de moteur (240) destiné à commander les éléments de commutation triphasés de telle manière qu'un moteur, entraîné par une puissance d'excitation fournie par l'unité d'onduleur, arrête de fonctionner par comparaison de la tension thermoélectrique avec une tension thermoélectrique de référence fixée pour commander l'entraînement du moteur,
où l'unité de mesure de chaleur (230) comprend :

un élément de thermistance soudé à un motif d'élément formé sur les deux côtés du motif de circulation thermique sur la carte de circuit imprimé, ledit élément de thermistance étant disposé sur le motif de circulation thermique de manière à chevaucher verticalement le motif de circulation thermique, la valeur de résistance de l'élément de thermistance étant variée proportionnellement à la chaleur ; et
un motif de mesure de chaleur destiné à mesurer la chaleur sur la base de la valeur de résistance variable de l'élément de thermistance (NTC ou PTC),

l'élément de thermistance étant disposé à proximité de n'importe quel élément de commutation parmi les éléments de commutation triphasés, l'élément de thermistance (NTC ou PTC) comprenant :

une première et une deuxième parties conductrices soudées au motif d'élément ; et
une partie isolante (a) disposée sur le motif de circulation thermique de telle manière que sa valeur de résistance est variée par la chaleur, et

la distance entre la première et la deuxième parties conductrices ou la largeur (d) de la partie isolante étant supérieure à la largeur (b) du motif de circulation thermique.

**8.** Dispositif de commande de moteur selon la revendication 7,
où l'élément de thermistance est une thermistance NTC, dont la valeur de résistance diminue proportionnellement à la chaleur.

**9.** Dispositif de commande de moteur selon la revendication 7,
où l'unité de mesure de chaleur (230) comporte en outre :

une résistance de référence (R1), dont un côté reçoit une tension de référence qui lui est appliquée, et dont l'autre côté est connecté à un côté de l'élément de thermistance sur un contact de distribution ; et
un filtre à résonance RC connecté au contact de distribution et destiné à supprimer le bruit de la tension thermoélectrique appliquée sur le contact de distribution et à sortir la tension thermoélectrique vers le contrôleur de moteur.

**10.** Dispositif de commande de moteur selon la revendication 9, où une tension de référence est appliquée sur un côté de l'élément de thermistance.

**11.** Dispositif de commande de moteur selon la revendication 9 ou la revendication 10, où l'élément de thermistance est une thermistance PCT, dont la valeur de résistance augmente proportionnellement à la chaleur.

**12.** Dispositif de commande de moteur selon la revendication 7,
où les éléments de commutation triphasés comprennent un élément de commutation de première phase, un élément de commutation de troisième phase, et un élément de commutation de deuxième phase disposé entre l'élément de commutation de première phase et l'élément de commutation de troisième phase, et
où l'élément de thermistance est disposé à proximité de l'élément de commutation de deuxième phase.

**13.** Dispositif de commande de moteur selon la revendication 7, où, si la tension thermoélectrique (Vptc) est inférieure à la tension thermoélectrique de référence, le contrôleur de moteur (240) commande l'arrêt de fonctionnement du moteur par les éléments de commutation triphasés.

FIG. 1

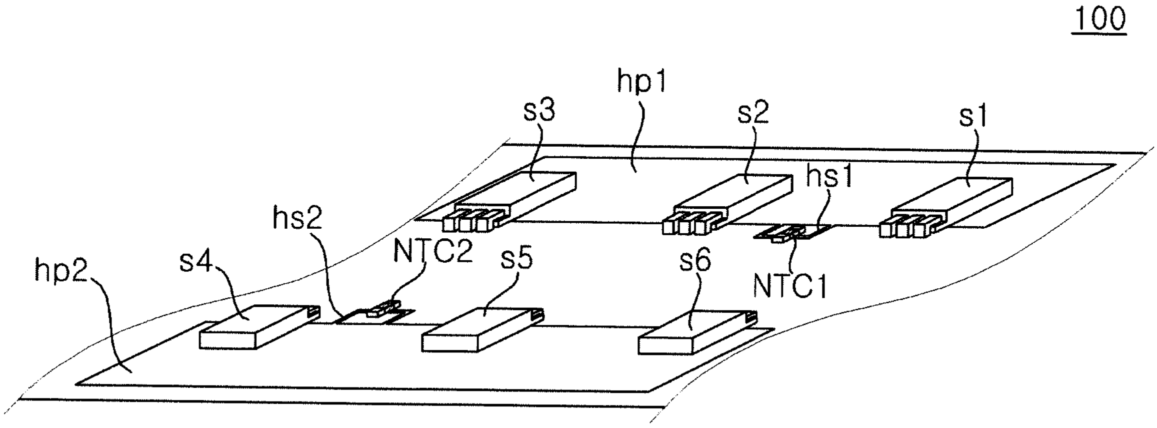

FIG. 2

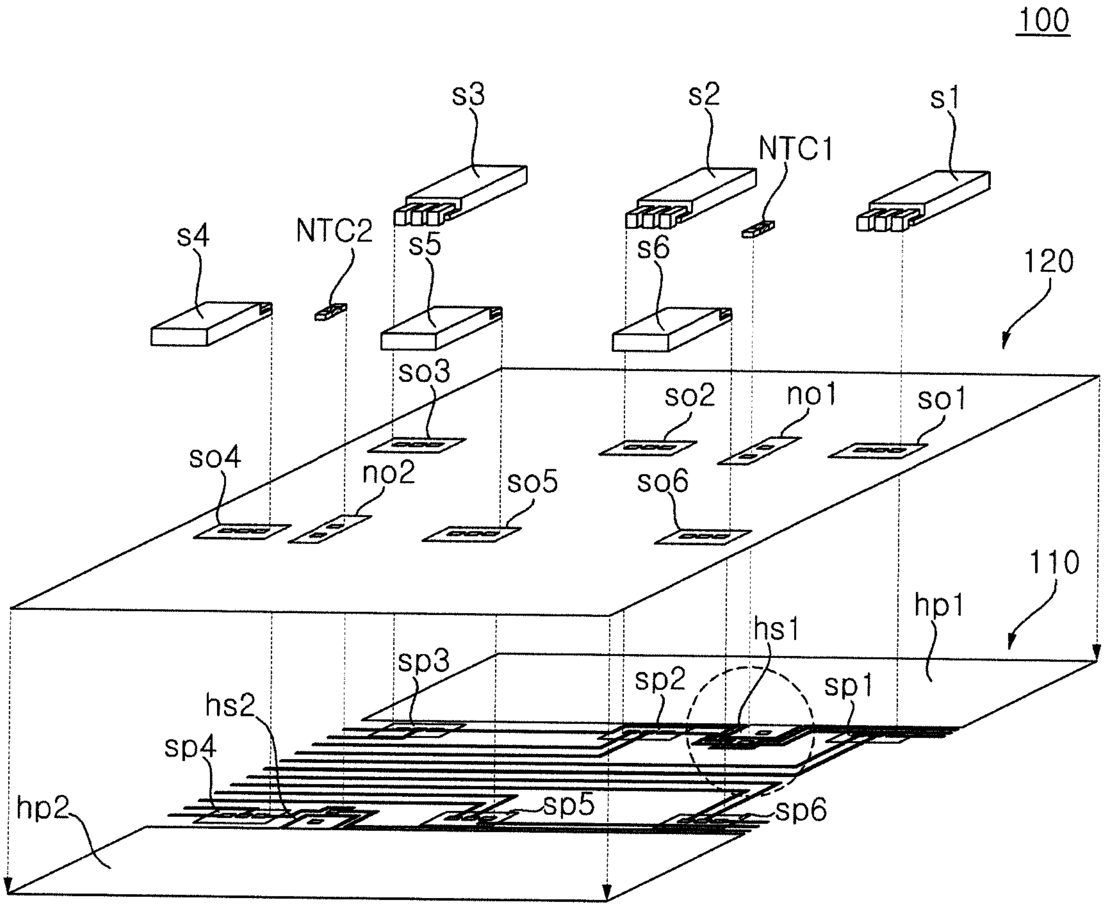
100
s3
s2
s1
NTC1
s4
NTC2
s5
s6
120
so3
so2
no1
so1
so4
no2
so5
so6
110
hp1
hs1
sp3
sp2
sp1
hs2
sp4
sp5
sp6
hp2

FIG. 3

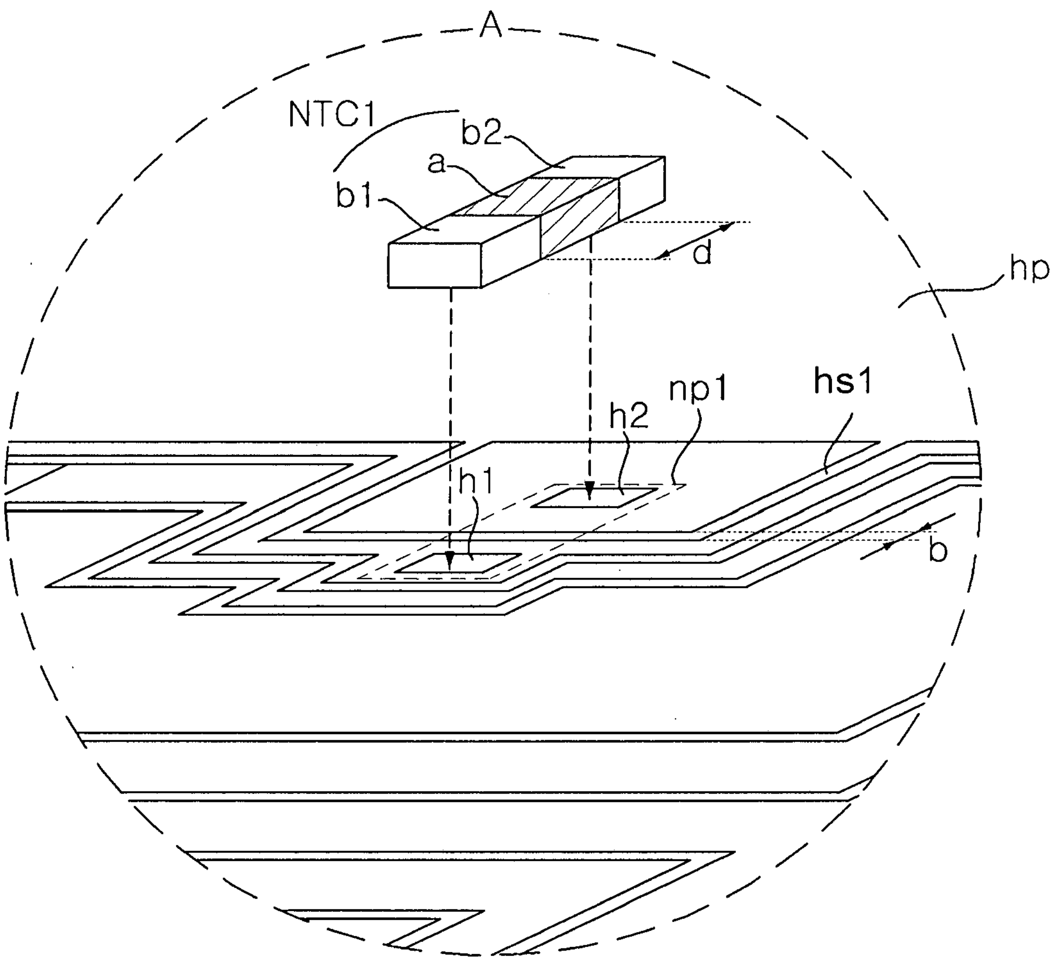

FIG. 4

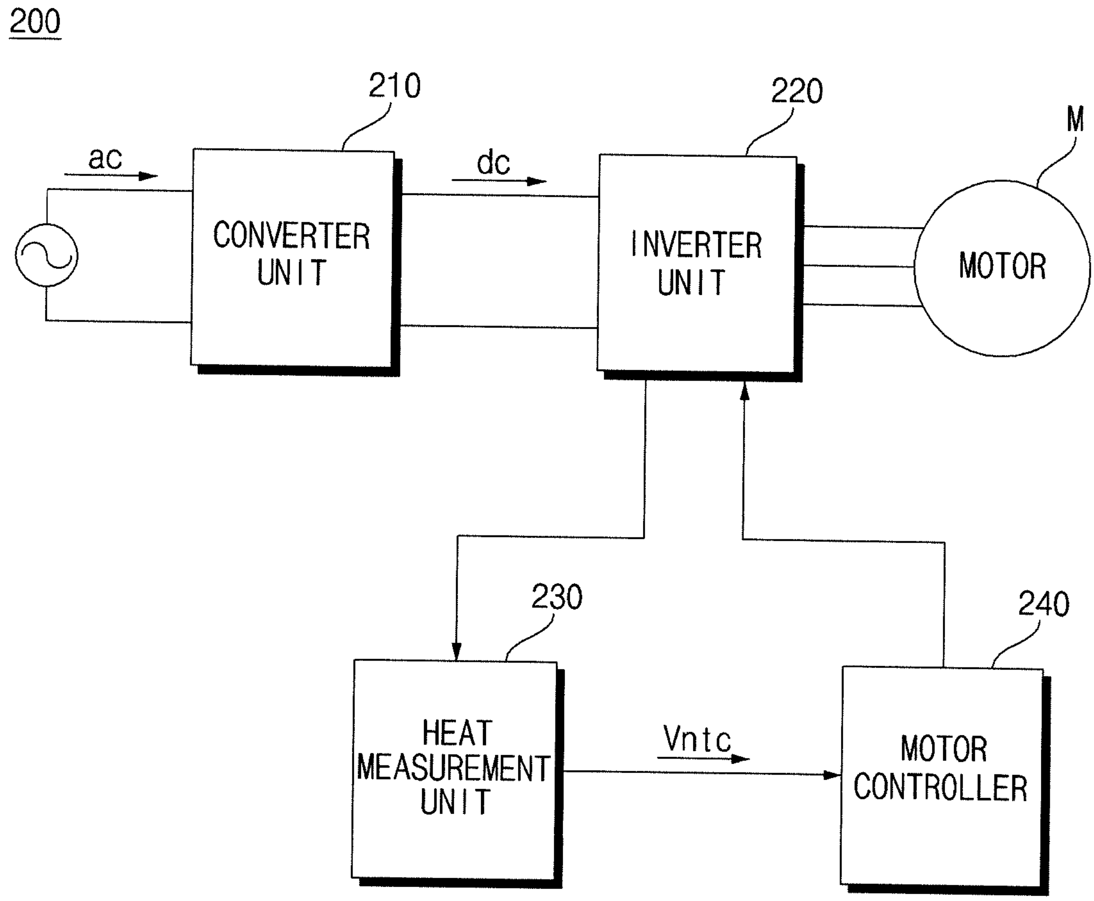
200
210
220
M
ac
dc
CONVERTER UNIT
INVERTER UNIT
MOTOR
230
240
HEAT MEASUREMENT UNIT
Vntc
MOTOR CONTROLLER

FIG. 5

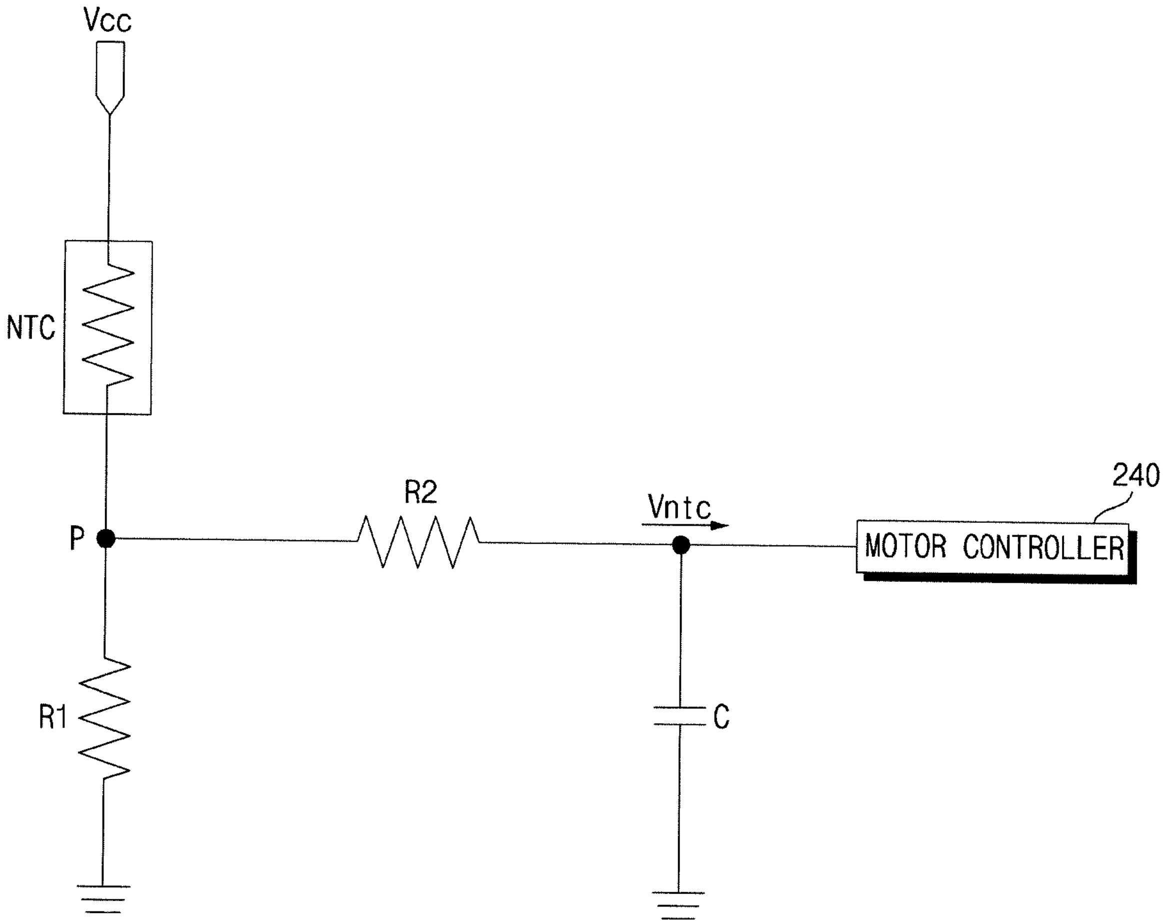

FIG. 6

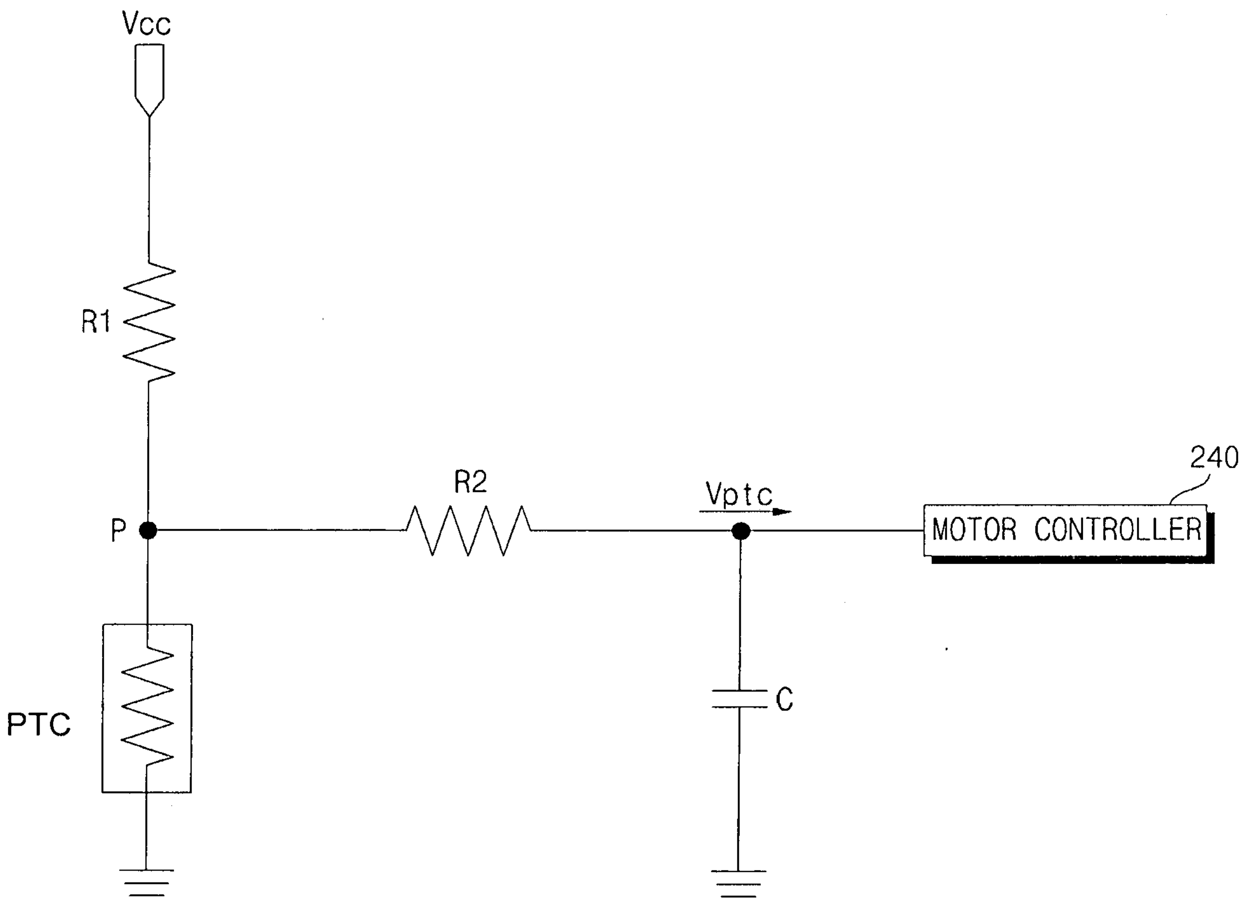

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 2651015 A1
- WO 2012137597 A1
- JP 2011033479 A